# EUROPÄISCHE PATENTSCHRIFT

(11) **EP 3 619 739 B1**
(45) Veröffentlichungstag und Bekanntmachung des Hinweises auf die Patenterteilung: **14.04.2021**
(21) Anmeldenummer: 18720237.9
(22) Anmeldetag: 25.04.2018
(51) Int. Cl.: H01L 23/495

(54) **HALBLEITERMODUL**
SEMICONDUCTOR MODULE
MODULE À SEMI-CONDUCTEUR

(30) Priorität: 05.05.2017 DE 102017207564
(43) Veröffentlichungstag der Anmeldung: 11.03.2020
(73) Patentinhaber: Robert Bosch GmbH, 70442 Stuttgart (DE)
(72) Erfinder: PROEPPER, Thomas, 72793 Pfullingen (DE)
(86) Internationale Anmeldenummer: PCT/EP2018/060603
(87) Internationale Veröffentlichungsnummer: WO 2018/202509

(56) Entgegenhaltungen:
- EP-A1- 2 546 874
- WO-A1-2014/206693
- US-A1- 2014 361 420

## Beschreibung

Die Erfindung geht aus von einem Halbleitermodul nach der Gattung des unabhängigen Patentanspruchs 1.

Aus dem Stand der Technik sind als integrierte Halbbrückenschaltungen (B2) in Moldgehäusen ausgeführte Halbleitermodule bekannt, welche beispielsweise als "leadless Chip-Scale-Packages" (anschlussloses Gehäuse in der Größenordnung eines Dies) aufgebaut sind. Diese Bauform ist beispielsweise zum Aufbau leistungselektronischer Pulswechselrichterbaugruppen auf Leiterplatten bestimmt. Das Moldgehäuse schließt bündig mit exponierten Oberflächen von elektrischen Leitungselementen ab, mit welchen die Halbbrückenschaltung auf die Leiterplatte gelötet ist. Die elektrischen Leitungselemente können beispielsweise als Leadframes ausgeführt werden. In dieser "anschlusslosen"-Bauweise erstrecken sich die elektrischen Leitungselemente der Halbbrückenschaltungen nicht über die Außenberandungen des Moldgehäuses hinaus. Die Halbbrückenschaltung umfasst zwei Transistoren, welche innerhalb eines Gehäuses jeweils zwischen zwei elektrischen Leitungselementen angeordnet und mit den elektrischen Leitungselementen elektrisch leitend verbunden sind. Ströme aus der Halbbrückenschaltung fließen über die Leiterplatte und erzeugen dort in unmittelbarer Umgebung der exponierten Oberflächen der elektrischen Leitungselemente hohe Verlustleistungsdichten. Der in den Schaltungsträger eingeleitete Phasenstrom der Halbbrückenschaltung wird dort mittels eines Abgriffs mit dem Phasenstromdraht verbunden, welcher in eine Statorwicklung einer angeschlossenen elektrischen Maschine übergeht.

Eine Strombrücke zwischen einem Drain-Anschluss eines ersten, Low-Side-Transistors und einem Source-Anschluss eines zweiten, High-Side-Transistors stellt in aus dem Stand der Technik bekannten Halbbrückenschaltungen ein High-Side-Leitungselement her, das einerseits mit einer Source-Elektrode des High-Side-Transistors und andererseits an einer Lotstelle, welche einen wesentlich geringeren Stromquerschnitt aufweist, mit einer Drain-Elektrode des Low-Side-Transistors verlötet ist. In thermischer und thermomechanischer Hinsicht ist diese Lot- oder auch Bondverbindung aufgrund der hohen lokalen Strom- und Verlustleistungsdichten im Bereich der Lotstelle kritisch; sie birgt ein signifikantes Zuverlässigkeitsrisiko durch Ausfall der Strombrücke infolge von Lotstellenbruch oder Lotstellenriss sowie Molddelamination.

Aus der DE 10 2009 006 152 A1 ist ein Elektronikbauelement bekannt, welches einen Systemträger, einen ersten Hableiterchip, einen zweiten Halbleiterchip und einen metallischen Clip umfasst, welche von einem Moldgehäuse umgeben sind.

Der erste Halbleiterchip ist mit einer ersten Oberfläche auf dem Systemträger aufgebracht. Der metallische Clip ist S-förmig gebogen und verbindet eine zweite Oberfläche des ersten Halbleiterchips, welche der ersten Oberfläche gegenüberliegt, mit einer ersten Oberfläche des zweiten Halbleiterchips, wobei die erste Oberfläche des zweiten Halbleiters in einer anderen Ebene des Elektronikbauelements angeordnet ist. Eine zweite Oberfläche des zweiten Halbleiterchips kann mit einem zweiten metallischen Clip verbunden werden. Die metallischen Clips können durch Stanzen, Prägen, Pressen, Schneiden, Sägen, Fräsen hergestellt werden.

Die EP 2 546 874 A1 offenbart ein Halbleitermodul mit mindestens zwei Halbleiterbauteilen, welche innerhalb eines Gehäuses jeweils zwischen zwei elektrischen Leitungselementen angeordnet sind und mit den elektrischen Leitungselementen elektrisch leitend verbunden sind, wobei die elektrischen Leitungselemente jeweils einen Kontaktfortsatz aufweisen, welcher aus dem Gehäuse geführt ist, wobei die Kontaktfortsätze in unterschiedlichen Ebenen angeordnet sind.

### Offenbarung der Erfindung

Das Halbleitermodul mit den Merkmalen des unabhängigen Patentanspruchs 1 hat den Vorteil, dass eine Strombrücke zwischen den beiden Halbleiterchips außerhalb des Gehäuses geschlossen ist. Dadurch können eine Stromeinschnürung im Kontaktansatz des elektrischen Leitungselements und ein damit verbundenes Zuverlässigkeitsrisiko durch hohe elektrische Stromdichten und Temperaturhübe in vorteilhafter Weise beseitigt werden. Ausführungsformen des erfindungsgemäßen Halbleitermoduls können in vorteilhafter Weise als Halbbrückenschaltungen ausgeführt und für den Aufbau auf einem elektronischen Schaltungsträger vorgesehen werden, welcher mit einer elektrischen Maschine unmittelbar zu einem "Power-Pack" zusammengesetzt ist. In vorteilhafter Weise kann ein Phasenpotentialabgriff der korrespondierenden Halbbrückenschaltung unmittelbar mit einem Phasenstromdraht einer Statorwicklung der elektrischen Maschine verbunden werden, ohne den Phasenstrom durch den Schaltungsträger zu führen, auf welchem das Halbleitermodul angeordnet ist. Des Weiteren können Ausführungsformen des erfindungsgemäßen Halbleitermoduls einen elektrischen Brückenpfad mit geringer Induktivität zur Verfügung stellen, so dass die Halbbrückenschaltungen in vorteilhafter Weise in Pulswechselrichterschaltungen mit hoher PWM-Frequenz (PWM: Pulsweitenmodulation) und miniaturisierten passiven Bauelementen eingesetzt werden können.

Zudem entfällt durch den außerhalb des Gehäuses geführten Strompfad in vorteilhafter Weise der Wärmeeintrag mit hoher Verlustleistungsdichte im Inneren des Halbleitermoduls und die damit einhergehenden Zuverlässigkeitsrisiken durch Delamination des Moldgehäuses, Lotstellenbrüche, Bondabrisse usw. Ausführungsformen des vorgeschlagenen Halbleitermoduls weisen im Inneren keine Stromeinschnürungen auf und sind demzufolge elektrisch und thermisch wesentlich höher belastbar bei zumindest gleicher Zuverlässigkeit und Lebensdauer wie vergleichbare Leistungshalbleitermodule herkömmlicher Bauart.

Die Elektroden, Anschlüsse und Abmessungen der Halbleiter der Halbbrücke können in vorteilhafter Weise gleich groß ausgeführt werden, so dass theoretisch eine maximale Stromlast bei vorgegebener Gesamtchipfläche und zulässiger Maximaltemperatur appliziert werden kann. Zudem kann der Phasenabgriff mittig im Strompfad der Halbbrücke platziert werden. Die elektrischen Schichten der beiden Halbleiterbauteile der Halbbrücke können kongruent und elektrisch symmetrisch zueinander aufgebaut werden.

Ausführungsformen der vorliegenden Erfindung stellen ein Halbleitermodul mit mindestens zwei Halbleiterbauteilen zur Verfügung, welche innerhalb eines Gehäuses jeweils zwischen zwei elektrischen Leitungselementen angeordnet sind und mit den elektrischen Leitungselementen elektrisch leitend verbunden sind. Hierbei weisen die elektrischen Leitungselemente jeweils einen Kontaktfortsatz auf, welcher aus dem Gehäuse geführt ist. Zudem sind zwei in unterschiedlichen Ebenen angeordnete Kontaktfortsätze außerhalb des Gehäuses über ein Kontaktelement miteinander verbunden, welches außerhalb des Gehäuses einen Strompfad zwischen den beiden Kontaktfortsätzen ausbildet.

Durch die in den abhängigen Ansprüchen aufgeführten Maßnahmen und Weiterbildungen sind vorteilhafte Verbesserungen des im unabhängigen Patentanspruch 1 angegebenen Halbleitermoduls möglich.

Besonders vorteilhaft ist, dass das Kontaktelement beispielsweise mittels Löten, Widerstands- oder Laserschweißen, Schneid-Klemmung, Crimpen oder Einpressverbinden mit den Kontaktfortsätzen verbunden werden kann. Selbstverständlich können auch andere geeignete Verbindungstechniken eingesetzt werden, um die Kontaktfortsätze elektrisch mit dem Kontaktelement zu verbinden und den korrespondierenden Strompfad auszubilden.

In vorteilhafter Ausgestaltung des Halbleitermoduls können die mindestens zwei Halbleiterbauteile als Leistungshalbleiterbauteile ausgeführt werden, welche den gleichen Flächenbedarf aufweisen und eine Halbbrückenschaltung für eine elektrische Maschine ausbilden. So können die Halbleiterbauteile beispielsweise als IGBTs (Insulated Gate Bipolar Transistors), MOSFET (Metal-Oxide-Semiconductor Field-Effect Transistor, Metall-Oxid-Halbleiter-Feldeffekttransistor), usw. ausgeführt werden.

In weiterer vorteilhafter Ausgestaltung des Halbleitermoduls können ein erstes elektrisches Leitungselement des ersten Halbleiters und ein erstes elektrisches Leitungselement des zweiten Halbleiters jeweils als Drain-Anschluss oder Kollektor-Anschluss ausgebildet werden, und ein zweites elektrisches Leitungselement des ersten Halbleiters und ein zweites elektrisches Leitungselement des zweiten Halbleiters können jeweils als Source-Anschluss oder Emitter-Anschluss ausgebildet werden. Des Weiteren können die beiden Drain-Anschlüsse oder Kollektor-Anschlüsse mit parallelen und fluchtenden Kanten in einer gemeinsamen ersten Ebene angeordnet werden. Die beiden Source-Anschlüsse oder Emitter-Anschlüsse können mit parallelen und fluchtenden Kanten in einer gemeinsamen zweiten Ebene angeordnet werden. Somit weisen die elektrischen Schichten der beiden Halbleiterbauteile der Halbbrücke in vorteilhafter Weise eine gleich hohe Stromtragfähigkeit und innerhalb des Gehäuses planare, gleichförmige Konturen mit geradlinigen Kanten auf, welche hinsichtlich Delamination und Rissbildung widerstandsfähiger gegenüber thermomechanischer Beanspruchung als herkömmliche Halbleitermodulpackages sind.

In weiterer vorteilhafter Ausgestaltung des Halbleitermoduls kann innerhalb des Gehäuses ein erster Drain-Anschluss oder Kollektor-Anschluss über eine Kontaktierungsschicht mit einer korrespondierenden Drain-Elektrode oder Kollektor-Elektrode des ersten Halbleiterbauteils und ein erster Source-Anschluss oder Emitter-Anschluss kann über eine Kontaktierungsschicht mit einer korrespondierenden Source-Elektrode oder Emitter-Elektrode des ersten Halbleiterbauteils und ein erster Gate-Anschluss oder Basis-Anschluss kann über eine Kontaktierungsschicht mit einer korrespondierenden Gate-Elektrode oder Basis-Elektrode des ersten Halbleiterbauteils verbunden werden. Zudem kann innerhalb des Gehäuses ein zweiter Drain-Anschluss oder Kollektor-Anschluss über eine Kontaktierungsschicht mit einer korrespondierenden Drain-Elektrode oder Kollektor-Elektrode des zweiten Halbleiterbauteils und ein zweiter Source-Anschluss oder Emitter-Anschluss kann über eine Kontaktierungsschicht mit einer korrespondierenden Source-Elektrode oder Emitter-Elektrode des zweiten Halbleiterbauteils und ein zweiter Gate-Anschluss oder Basis-Anschluss kann über eine Kontaktierungsschicht mit einer korrespondierenden Gate-Elektrode oder Basis-Elektrode des zweiten Halbleiterbauteils verbunden werden. In vorteilhafter Weise können nur die Gate-Anschlüsse oder Basis-Anschlüsse der beiden Halbleiterbauteile elektrisch mit einer Leiterplatte kontaktiert werden, so dass nur leistungsarme Ansteuersignale über die Leiterplatte geleitet werden. Die Hochleistungsströme fließen über den außerhalb des Gehäuses angeordneten Strompfad, welcher durch die nicht mit der Leiterplatte kontaktierten Kontaktfortsätze und das Kontaktelement ausgebildet wird.

In weiterer vorteilhafter Ausgestaltung des Halbleitermoduls kann ein Endabschnitt eines Phasenstromdrahts einer elektrischen Maschine das Kontaktelement ausbilden. Dadurch kann derselbe Endabschnitt des Phasenstromdrahts, welcher unmittelbar mit dem Phasenpotentialabgriff des vorgeschlagenen Halbleitermoduls verbunden ist, die Strombrücke zwischen dem ersten Halbleiter und dem zweiten Halbleiter schließen.

In weiterer vorteilhafter Ausgestaltung des Halbleitermoduls kann das Gehäuse als Moldgehäuse ausgeführt werden. Zudem kann eine nach außen gewandte offenliegende Oberfläche der beiden ersten elektrischen Leitungselemente jeweils bündig mit einer Unterseite des Gehäuses abschließen. Des Weiteren kann eine nach außen gewandte offenliegende Oberfläche der beiden zweiten elektrischen Leitungselemente jeweils bündig mit einer Oberseite des Gehäuses abschießen. Dadurch kann das Gehäuse in vorteilhafter Weise einfach mit seiner Unterseite auf eine Leiterplatte oder eine Wärmesenke aufgesetzt werden. Alternativ kann das Gehäuse über seine Oberseite einfach auf die Leiterplatte oder die Wärmesenke aufgesetzt werden. Zudem ist es möglich, das Gehäuse mit seiner Unterseite auf die Leiterplatte aufzusetzen und auf die Oberseite des Gehäuses zusätzlich die Wärmesenke aufzusetzen.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Seitenansicht eines ersten Ausführungsbeispiels eines erfindungsgemäßen Halbleitermoduls in einer Slug-up-Bauform.
Fig. 2 zeigt eine schematische perspektivische Draufsicht auf das Ausführungsbeispiel des erfindungsgemäßen Halbleitermoduls aus Fig. 1.
Fig. 3 zeigt eine schematische perspektivische Draufsicht auf das Ausführungsbeispiel des erfindungsgemäßen Halbleitermoduls aus Fig. 1 und 2 ohne Gehäuse.
Fig. 4 zeigt eine schematische perspektivische Draufsicht auf das Ausführungsbeispiel des erfindungsgemäßen Halbleitermoduls aus Fig. 3 ohne zweites elektrisches Leitungselement.
Fig. 5 zeigt eine schematische perspektivische Darstellung eines Ausführungsbeispiels eines Strompfads zwischen einem ersten elektrischen Leitungselement eines ersten Halbleiters und einem zweiten elektrischen Leitungselement eines zweiten Halbleiters des erfindungsgemäßen Halbleitermoduls aus Fig. 1 und bis 4.
Fig. 6 zeigt eine schematische Darstellung eines weiteren Ausführungsbeispiels des Strompfads aus Fig. 5.
Fig. 7 zeigt eine schematische perspektivische Draufsicht eines zweiten Ausführungsbeispiels eines erfindungsgemäßen Halbleitermoduls in einer Slug-down-Bauform.
Fig. 8 zeigt eine schematische perspektivische Ansicht des zweiten Ausführungsbeispiels des erfindungsgemäßen Halbleitermoduls aus Fig. 7 von unten.

### Ausführungsformen der Erfindung

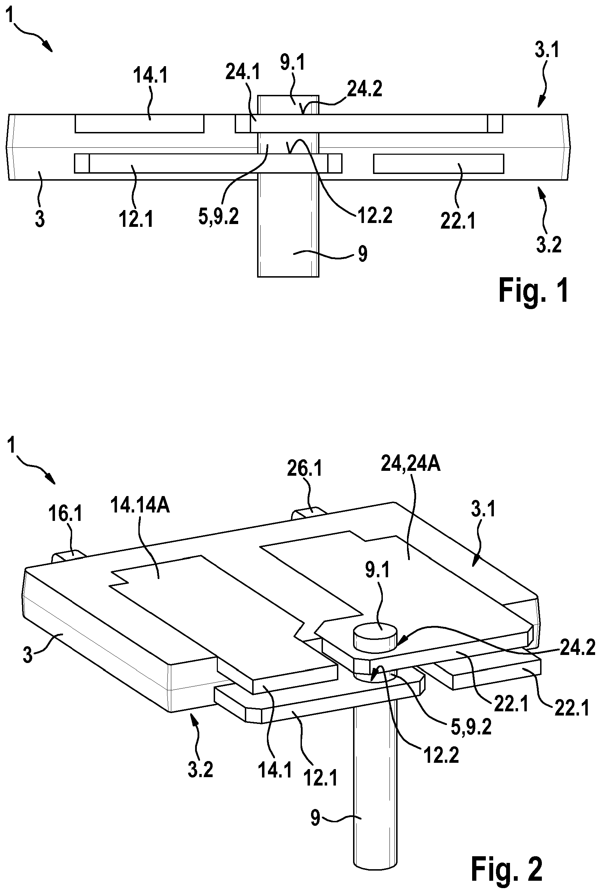

Wie aus Fig. 1 bis 8 ersichtlich ist, umfassen die dargestellten Ausführungsbeispiele eines erfindungsgemäßen Halbleitermoduls 1 jeweils mindestens zwei Halbleiterbauteile 10, 20, welche innerhalb eines Gehäuses 3 jeweils zwischen zwei elektrischen Leitungselementen 12, 14, 22, 24 angeordnet und mit den elektrischen Leitungselementen 12, 14, 22 ,24 elektrisch leitend verbunden sind. Hierbei weisen die elektrischen Leitungselemente 12, 14, 22, 24 jeweils einen Kontaktfortsatz 12.1, 14.2, 22.1, 24.1 auf, welcher aus dem Gehäuse 3 geführt ist. Zudem sind zwei in unterschiedlichen Ebenen angeordnete Kontaktfortsätze 12.1, 24.1 außerhalb des Gehäuses 3 über ein Kontaktelement 5 miteinander verbunden, welches außerhalb des Gehäuses 3 einen Strompfad zwischen den beiden Kontaktfortsätzen 12.1, 24.1 ausbildet.

Wie aus Fig. 1 bis 8 weiter ersichtlich ist, verläuft das Kontaktelement 5 im Wesentlichen senkrecht zwischen den beiden Kontaktfortsätzen 12.1, 24.1. Das Kontaktelement 5 ist beispielsweise mittels Löten, Widerstands- oder Laserschweißen, Schneid-Klemmung, Crimpen oder Einpressverbinden mit den Kontaktfortsätzen 12.1, 24.1 verbunden.

Wie aus Fig. 1 bis 8 weiter ersichtlich ist, bilden die dargestellten Ausführungsbeispielspiele der Halbleitermodule 1 jeweils ein elektronisches Leistungsmodul aus, welches eine elektrisch und thermisch hoch belastbare Halbbrückenschaltung aus zwei Halbleiterbauteilen 10, 20 in einem einteiligen Gehäuse 3 umfasst, welches unmittelbar mit einem Phasenstromdraht 9 einer Erregerwicklung einer nicht dargestellten, angeschlossenen elektrischen Maschine verbunden ist. Die beiden Halbleiterbauteile 10, 20 sind in den dargestellten Ausführungsbeispielen als MOSFETs (Metall-Oxid-Halbleiter-Feldeffekttransistoren) ausgeführt, welche den gleichen Flächenbedarf aufweisen. Bei einem nicht dargestellten alternativen Ausführungsbeispiel können die beiden Halbleiterbauteile 10, 20 als IGBTs (Insulated Gate Bipolar Transistors) ausgeführt werden.

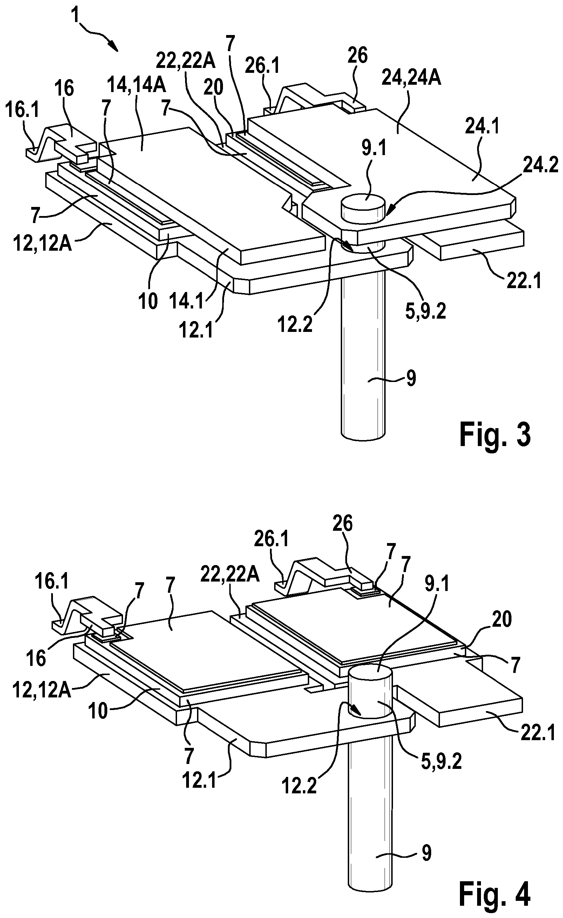

Fig. 3 und 4 zeigen die inneren Einzelheiten des Halbleitermoduls 1 ohne dessen Gehäuse 3. Wie aus Fig. 3 und 4 weiter ersichtlich ist, sind ein erstes elektrisches Leitungselement 12 eines ersten Halbleiters 10 und ein erstes elektrisches Leitungselement 22 eines zweiten Halbleiters 20 jeweils als Drain-Anschluss 12A, 22A ausgebildet. Zudem sind ein zweites elektrisches Leitungselement 14 des ersten Halbleiters 10 und ein zweites elektrisches Leitungselement 24 des zweiten Halbleiters 20 jeweils als Source-Anschluss 14A, 24A ausgebildet. Hierbei sind die beiden Drain-Anschlüsse 12A, 22A mit parallelen und fluchtenden Kanten in einer gemeinsamen ersten Ebene angeordnet. Die beiden Source-Anschlüsse 14A, 24A sind mit parallelen und fluchtenden Kanten in einer gemeinsamen zweiten Ebene angeordnet. Wie aus Fig. 3 und 4 weiter ersichtlich ist, ist ein erster Drain-Anschluss 12A über eine Kontaktierungsschicht 7 mit einer korrespondierenden Drain-Elektrode des ersten Halbleiterbauteils 10 verbunden. Ein erster Source-Anschluss 14A ist über eine Kontaktierungsschicht 7 mit einer korrespondierenden Source-Elektrode des ersten Halbleiterbauteils 10 verbunden. Ein erster Gate-Anschluss 16 ist über eine Kontaktierungsschicht 7 mit einer korrespondierenden Gate-Elektrode des ersten Halbleiterbauteils 10 verbunden. Zudem ist ein zweiter Drain-Anschluss 22A über eine Kontaktierungsschicht 7 mit einer korrespondierenden Drain-Elektrode des zweiten Halbleiterbauteils 20 verbunden. Ein zweiter Source-Anschluss 24A ist über eine Kontaktierungsschicht 7 mit einer korrespondierenden Source-Elektrode des zweiten Halbleiterbauteils 20 verbunden. Ein zweiter Gate-Anschluss 26 ist über eine Kontaktierungsschicht 7 mit einer korrespondierenden Gate-Elektrode des zweiten Halbleiterbauteils 20 verbunden. Die Kontaktierungsschichten 7 können beispielsweise als Lotschichten, Leitkleberschichten usw. ausgebildet werden.

Der Schichtaufbau "Drain-Anschluss-Kontaktierungsschicht-Halbleiterbauteil-Kontaktierungsschicht-Source-Anschluss" des ersten "Low-Side" Brückenpfads ist elektrisch symmetrisch zum Schichtaufbau "Drain-Anschluss-Kontaktierungsschicht-Halbleiterbauteil-Kontaktierungsschicht-Source-Anschluss" des zweiten "High-Side" Brückenpfads ausgeführt. Entgegen der herkömmlichen Art, die Strombrücke zwischen dem ersten Drain-Anschluss 12A und dem zweiten Source-Anschluss 24A mittels eines gelöteten Verbinders oder Bonddrahts innerhalb des Gehäuses 3 zu schließen, wird eine Verbindung des Kontaktfortsatzes 12.1 des ersten Drain-Anschlusses 12A und des Kontaktfortsatzes 24.1 des zweiten Source-Anschlusses 24A durch einen Endabschnitt 9.1 des Phasenstromdrahts 9 vorgeschlagen. Diese Verbindung kann mittels Löten, Widerstands- oder Laserschweißen, Schneid-Klemmung, Crimpen oder Einpressverbinder hergestellt werden, da sie außerhalb des als Moldgehäuses ausgeführten Gehäuses 3 angeordnet ist. Ein Mittelpunkt eines Phasendrahtabschnitts 9.2 bildet den Phasenpotentialabgriff aus. Dieser teilt den Strompfad der Halbbrücke elektrisch symmetrisch in einen "Low-Side" Pfad und einen "High-Side" Pfad von gleicher Impedanz, welche eine geringe Induktivität sowie einen geringen ohmschen Widerstand aufweist.

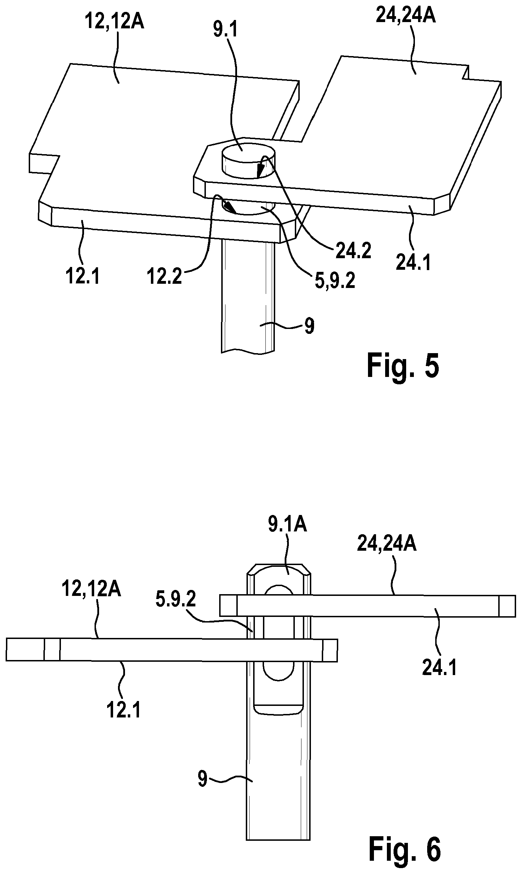

Wie insbesondere aus Fig. 5 und 6 weiter ersichtlich ist, bildet ein Endabschnitt 9.1 eines Phasenstromdrahts 9 einer elektrischen Maschine das Kontaktelement 5 aus. Wie aus Fig. 6 weiter ersichtlich ist, ist der Endabschnitt 7.1 des Phasenstromdrahts 9 als Einpressöse 9.1A ausgeführt, welche in entsprechende Kontaktöffnungen 12.2, 24.2 im Kontaktfortsatz 12.1 des ersten Drain-Anschlusses 12A und im Kontaktfortsatz 24.1 des zweiten Source-Anschlusses 24A eingepresst ist.

Wie aus Fig. 1 und 2 weiter ersichtlich ist, schließt bei einer Slug-up-Bauform des Halbleitermoduls 1 eine Oberseite 3.1 des Gehäuses 3 bündig mit äußeren, offenliegenden Oberflächen der beiden parallel und fluchtend angeordneten Source-Anschlüsse 14A, 24A ab, welche über ein thermisch leitfähiges, galvanisch trennendes Zwischenmedium mit einer nicht näher dargestellten Wärmesenke verbunden werden können. Eine Unterseite 3.2 des Gehäuses 3 wird ausschließlich von einer Moldmasse des Gehäuses 3 gebildet. Die Unterseite 3.2 des Gehäuses 3 ist elektrisch potentialfrei und kann technisch vorteilhaft mittels eines über Lebensdauer betriebsfesten, dauerelastischen Klebers mit einem nicht näher dargestellten Schaltungsträger verbunden werden. Der Schaltungsträger kann beispielsweise als mehrlagige Leiterplatte ausgeführt werden. Der Schaltungsträger und das Gehäuse 3 des Halbleitermoduls 1 können somit trotz unterschiedlicher thermischer Ausdehnungskoeffizienten thermomechanische Dehnungen riss- und delaminationsfrei vollziehen. Einzig die Kontaktfortsätze 16.1, 26.1 der Gate-Anschlüsse 16, 26 sind elektrisch mit dem Schaltungsträger verbunden. Hohe Ströme fließen jedoch nur durch die Kontaktfortsätze 12.1, 24.1 des Halbleitermoduls 1 und den Phasenstromdraht 9 und nicht durch den Schaltungsträger. Die ohmsche Verlustleistung im elektrischen Strömungsfeld des Halbleitermoduls 1 fließt deshalb überwiegend durch die offenliegenden Oberflächen der Drain-Anschlüsse 14A, 24A in die Wärmesenke ab. Der Schaltungsträger und die darauf angeordneten umliegenden Bauelemente werden thermisch und thermomechanisch nur geringfügig belastet.

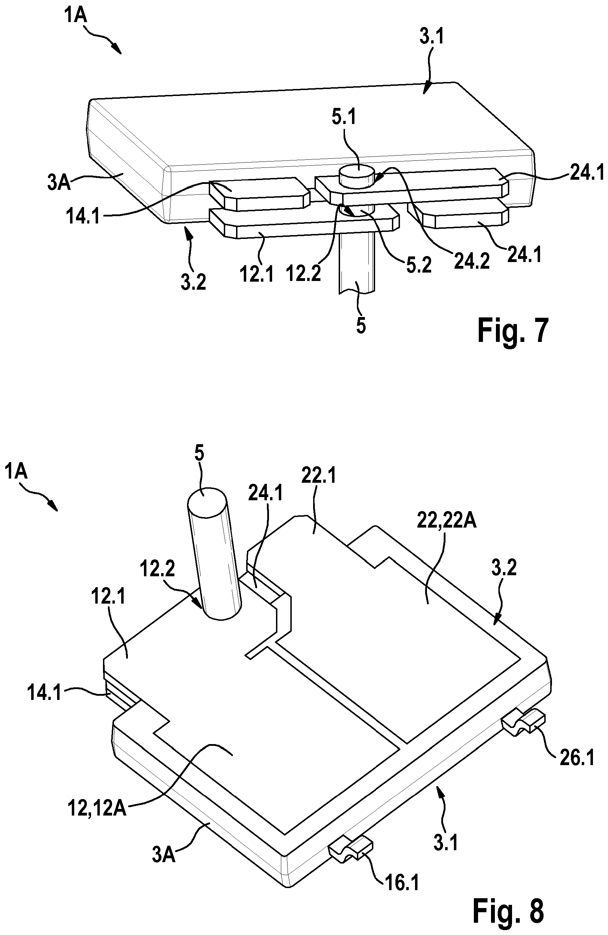

Wie aus Fig. 7 und 8 weiter ersichtlich ist, schließt bei einer Slug-down-Bauform des Halbleitermoduls 1 die Unterseite 3.2 des Gehäuses 3 bündig mit äußeren, offenliegenden Oberflächen der beiden parallel und fluchtend angeordneten Drain-Anschlüsse 12A, 22A ab. Eine der beiden offenliegenden Oberflächen der Drain-Anschlüsse 12A, 22A kann mit einer Lotfläche auf dem Schaltungsträger verlötet werden, so dass ein High-Side-Strom oder ein Low-Side-Strom über den Schaltungsträger fließen kann. Weiterhin kann eine der beiden offenliegenden Oberflächen der Drain-Anschlüsse 12A, 22A über ein plastisches, wärmeleitendes und elektrisch isolierendes Zwischenmedium mit einer rechteckigperiodischen bzw. hexagonalen Anordnung thermischer Durchkontaktierungen ("thermal vias") im Schaltungsträger verbunden werden, welche einen Wärmestrom des Halbleitermoduls 1 in eine nicht dargestellte Wärmesenke führen kann. Die Oberseite 3.1 des Gehäuses 3 wird ausschließlich von der Moldmasse des Gehäuses 3 gebildet.

## Patentansprüche

1. Halbleitermodul (1) mit mindestens zwei Halbleiterbauteilen (10, 20), welche innerhalb eines Gehäuses (3) jeweils zwischen zwei elektrischen Leitungselementen (12, 14, 22, 24) angeordnet sind und mit den elektrischen Leitungselementen (12, 14, 22 ,24) elektrisch leitend verbunden sind, wobei die elektrischen Leitungselemente (12, 14, 22, 24) jeweils einen Kontaktfortsatz (12.1, 14.2, 22.1, 24.1) aufweisen, welcher aus dem Gehäuse (3) geführt ist, **dadurch gekennzeichnet, dass** zwei in unterschiedlichen Ebenen angeordneten Kontaktfortsätze (12.1, 24.1) außerhalb des Gehäuses (3) über Kontaktelement (5) miteinander verbunden sind, welches außerhalb des Gehäuses (3) einen Strompfad zwischen den beiden Kontaktfortsätzen (12.1, 24.1) ausbildet.

2. Halbleitermodul (1) nach Anspruch 1, **dadurch gekennzeichnet, dass** das Kontaktelement (5) mittels Löten, Widerstands- oder Laserschweißen, Schneid-Klemmung, Crimpen oder Einpressverbinden mit den Kontaktfortsätzen (12.1, 24.1) verbunden ist.

3. Halbleitermodul (1) nach Anspruch 1 oder 2, **dadurch gekennzeichnet, dass** die mindestens zwei Halbleiterbauteile (10, 20) als Leistungshalbleiterbauteile ausgeführt sind, welche den gleichen Flächenbedarf aufweisen und eine Halbbrückenschaltung für eine elektrische Maschine ausbilden.

4. Halbleitermodul (1) nach einem der Ansprüche 1 bis 3, **dadurch gekennzeichnet, dass** ein erstes elektrisches Leitungselement (12) des ersten Halbleiters (10) und ein erstes elektrisches Leitungselement (22) des zweiten Halbleiters (20) jeweils als Drain-Anschluss (12A, 22A) oder Kollektor-Anschluss ausgebildet sind, und ein zweites elektrisches Leitungselement (14) des ersten Halbleiters (10) und ein zweites elektrisches Leitungselement (24) des zweiten Halbleiters (20) jeweils als Source-Anschluss (14A, 24A) oder Emitter-Anschluss ausgebildet sind.

5. Halbleitermodul (1) nach Anspruch 4, **dadurch gekennzeichnet, dass** die beiden Drain-Anschlüsse (12A, 22A) oder Kollektor-Anschlüsse mit parallelen und fluchtenden Kanten in einer gemeinsamen ersten Ebene angeordnet sind.

6. Halbleitermodul (1) nach Anspruch 4 oder 5, **dadurch gekennzeichnet, dass** die beiden Source-Anschlüsse (14A, 24A) oder Emitter-Anschlüsse mit parallelen und fluchtenden Kanten in einer gemeinsamen zweiten Ebene angeordnet sind.

7. Halbleitermodul (1) nach einem der Ansprüche 4 bis 6, **dadurch gekennzeichnet, dass** innerhalb des Gehäuses (3) ein erster Drain-Anschluss (12A) oder Kollektor-Anschluss über eine Kontaktierungsschicht (7) mit einer korrespondierenden Drain-Elektrode oder Kollektor-Elektrode des ersten Halbleiterbauteils (10) und ein erster Source-Anschluss (14A) oder Emitteranschluss über eine Kontaktierungsschicht (7) mit einer korrespondierenden Source-Elektrode oder Emitter-Elektrode des ersten Halbleiterbauteils (10) und ein erster Gate-Anschluss (16) oder Basis-Anschluss über eine Kontaktierungsschicht (7) mit einer korrespondierenden Gate-Elektrode oder Basis-Elektrode des ersten Halbleiterbauteils (10) verbunden sind.

8. Halbleitermodul (1) nach einem der Ansprüche 4 bis 7, **dadurch gekennzeichnet, dass** innerhalb des Gehäuses (3) ein zweiter Drain-Anschluss (22A) oder Kollektoranschluss über eine Kontaktierungsschicht (7) mit einer korrespondierenden Drain-Elektrode oder Kollektorelektrode des zweiten Halbleiterbauteils (20) und ein zweiter Source-Anschluss (24A) oder Emitter-Anschluss über eine Kontaktierungsschicht (7) mit einer korrespondierenden Source-Elektrode oder Emitter-Elektrode des zweiten Halbleiterbauteils (20) und ein zweiter Gate-Anschluss (26) oder Basis-Anschluss über eine Kontaktierungsschicht (7) mit einer korrespondierenden Gate-Elektrode oder Basis-Elektrode des zweiten Halbleiterbauteils (20) verbunden sind.

9. Halbleitermodul (1) nach Anspruch 7 oder 8, **dadurch gekennzeichnet, dass** nur die Gate-Anschlüsse (16, 26) oder Basis-Anschlüsse der beiden Halbleiterbauteile (10, 20) elektrisch mit einer Leiterplatte kontaktiert sind.

10. Halbleitermodul (1) nach einem der Ansprüche 1 bis 9, **dadurch gekennzeichnet, dass** ein Endabschnitt (9.1) eines Phasenstromdrahts (9) einer elektrischen Maschine das Kontaktelement (5) ausbildet.

11. Halbleitermodul (1) nach einem der Ansprüche 1 bis 10, **dadurch gekennzeichnet, dass** das Gehäuse (3) als Moldgehäuse ausgeführt ist.

12. Halbleitermodul (1) nach einem der Ansprüche 1 bis 11, **dadurch gekennzeichnet, dass** nach außen gewandte offenliegende Oberflächen der beiden ersten elektrischen Leitungselemente (12, 22) jeweils bündig mit einer Unterseite (3.2) des Gehäuses (3) abschließen.

13. Halbleitermodul (1) nach einem der Ansprüche 1 bis 12, **dadurch gekennzeichnet, dass** nach außen gewandte offenliegende Oberflächen der beiden zweiten elektrischen Leitungselemente (14, 24) jeweils bündig mit einer Oberseite (3.2) des Gehäuses (3) abschießen.

14. Halbleitermodul (1) nach Anspruch 12 oder 13, **dadurch gekennzeichnet, dass** das Gehäuse (3) mit seiner Unterseite (3.2) auf eine Leiterplatte oder eine Wärmesenke aufgesetzt ist.

15. Halbleitermodul (1) nach einem der Ansprüche 12 bis 14, **dadurch gekennzeichnet, dass** das Gehäuse (3) über seine Oberseite (3.1) auf die Leiterplatte oder die Wärmesenke aufgesetzt ist.

## Claims

1. Semiconductor module (1) comprising at least two semiconductor components (10, 20) which are arranged within a housing (3) in each case between two electrical conduction elements (12, 14, 22, 24) and are electrically conductively connected to the electrical conduction elements (12, 14, 22, 24), wherein the electrical conduction elements (12, 14, 22, 24) respectively have a contact extension (12.1, 14.2, 22.1, 24.1) that is led out of the housing (3), **characterized in that** two contact extensions (12.1, 24.1) arranged in different planes are connected to one another outside the housing (3) via contact element (5), which forms a current path between the two contact extensions (12.1, 24.1) outside the housing (3).

2. Semiconductor module (1) according to Claim 1, **characterized in that** the contact element (5) is connected to the contact extensions (12.1, 24.1) by means of soldering, resistance or laser welding, insulation-displacement connection, crimping or press-fit connection.

3. Semiconductor module (1) according to Claim 1 or 2, **characterized in that** the at least two semiconductor components (10, 20) are embodied as power semiconductor components which have the same area requirement and form a half-bridge circuit for an electrical machine.

4. Semiconductor module (1) according to any of Claims 1 to 3, **characterized in that** a first electrical conduction element (12) of the first semiconductor (10) and a first electrical conduction element (22) of the second semiconductor (20) are formed in each case as a drain terminal (12A, 22A) or a collector terminal, and a second electrical conduction element (14) of the first semiconductor (10) and a second electrical conduction element (24) of the second semiconductor (20) are formed in each case as a source terminal (14A, 24A) or an emitter terminal.

5. Semiconductor module (1) according to Claim 4, **characterized in that** the two drain terminals (12A, 22A) or collector terminals are arranged with parallel and aligned edges in a common first plane.

6. Semiconductor module (1) according to Claim 4 or 5, **characterized in that** the two source terminals (14A, 24A) or emitter terminals are arranged with parallel and aligned edges in a common second plane.

7. Semiconductor module (1) according to any of Claims 4 to 6, **characterized in that** within the housing (3) a first drain terminal (12A) or collector terminal is connected via a contacting layer (7) to a corresponding drain electrode or collector electrode of the first semiconductor component (10) and a first source terminal (14A) or emitter terminal is connected via a contacting layer (7) to a corresponding source electrode or emitter electrode of the first semiconductor component (10) and a first gate terminal (16) or base terminal is connected via a contacting layer (7) to a corresponding gate electrode or base electrode of the first semiconductor component (10).

8. Semiconductor module (1) according to any of Claims 4 to 7, **characterized in that** within the housing (3) a second drain terminal (22A) or collector terminal is connected via a contacting layer (7) to a corresponding drain electrode or collector electrode of the second semiconductor component (20) and a second source terminal (24A) or emitter terminal is connected via a contacting layer (7) to a corresponding source electrode or emitter electrode of the second semiconductor component (20) and a second gate terminal (26) or base terminal is connected via a contacting layer (7) to a corresponding gate electrode or base electrode of the second semiconductor component (20).

9. Semiconductor module (1) according to Claim 7 or 8, **characterized in that** only the gate terminals (16, 26) or base terminals of the two semiconductor components (10, 20) are electrically contacted with a printed circuit board.

10. Semiconductor module (1) according to any of Claims 1 to 9, **characterized in that** an end section (9.1) of a phase current wire (9) of an electrical machine forms the contact element (5).

11. Semiconductor module (1) according to any of Claims 1 to 10, **characterized in that** the housing (3) is embodied as a molded housing.

12. Semiconductor module (1) according to any of Claims 1 to 11, **characterized in that** outwardly facing open surfaces of the two first electrical conduction elements (12, 22) terminate in each case flush with an underside (3.2) of the housing (3).

13. Semiconductor module (1) according to any of Claims 1 to 12, **characterized in that** outwardly facing open surfaces of the two second electrical conduction elements (14, 24) terminate in each case flush with a top side (3.2) of the housing (3).

14. Semiconductor module (1) according to Claim 12 or 13, **characterized in that** the housing (3) is placed by its underside (3.2) onto a printed circuit board or a heat sink.

15. Semiconductor module (1) according to any of Claims 12 to 14, **characterized in that** the housing (3) is placed by way of its top side (3.1) onto the printed circuit board or the heat sink.

## Revendications

1. Module à semi-conducteur (1), comprenant au moins deux composants semi-conducteurs (10, 20) qui sont disposés à l'intérieur d'un boîtier (3) respectivement entre deux éléments conducteurs électriques (12, 14, 22, 24) et sont reliés de manière électriquement conductrice aux éléments conducteurs électriques (12, 14, 22 ,24), les éléments conducteurs électriques (12, 14, 22, 24) présentant respectivement un prolongement de contact (12.1, 14.2, 22.1, 24.1) qui sort du boîtier (3), **caractérisé en ce que** deux prolongements de contact (12.1, 24.1), disposés dans différents plans, sont reliés l'un à l'autre à l'extérieur du boîtier (3) par un élément de contact (5) qui réalise à l'extérieur du boîtier (3) un trajet de courant entre les deux prolongements de contact (12.1, 24.1).

2. Module à semi-conducteur (1) selon la revendication 1, **caractérisé en ce que** l'élément de contact (5) est relié aux prolongements de contact (12.1, 24.1) par brasage, par soudage par résistance ou au laser, par raccord à borne guillotine, par sertissage ou par emmanchement.

3. Module à semi-conducteur (1) selon la revendication 1 ou 2, **caractérisé en ce que** les au moins deux composants semi-conducteurs (10, 20) sont réalisés sous forme de composants semi-conducteurs de puissance qui présentent le même encombrement et réalisent un circuit en demi-pont pour une machine électrique.

4. Module à semi-conducteur (1) selon l'une quelconque des revendications 1 à 3, **caractérisé en ce qu'**un premier élément conducteur électrique (12) du premier semi-conducteur (10) et un premier élément conducteur électrique (22) du deuxième semi-conducteur (20) sont réalisés respectivement sous forme de borne de drain (12A, 22A) ou de borne de collecteur, et un deuxième élément conducteur électrique (14) du premier semi-conducteur (10) et un deuxième élément conducteur électrique (24) du deuxième semi-conducteur (20) sont réalisés respectivement sous forme de borne de source (14A, 24A) ou de borne d'émetteur.

5. Module à semi-conducteur (1) selon la revendication 4, **caractérisé en ce que** les deux bornes de drain (12A, 22A) ou bornes de collecteur sont disposées dans un premier plan commun, leurs bords étant parallèles et alignés.

6. Module à semi-conducteur (1) selon la revendication 4 ou 5, **caractérisé en ce que** les deux bornes de source (14A, 24A) ou bornes d'émetteur sont disposées dans un deuxième plan commun, leurs bords étant parallèles et alignés.

7. Module à semi-conducteur (1) selon l'une quelconque des revendications 4 à 6, **caractérisé en ce qu'**à l'intérieur du boîtier (3), une première borne de drain (12A) ou une borne de collecteur est reliée par une couche de mise en contact (7) à une électrode de drain ou à une électrode de collecteur correspondante du premier composant semi-conducteur (10), et une première borne de source (14A) ou une borne d'émetteur est reliée par une couche de mise en contact (7) à une électrode de source ou à une électrode d'émetteur correspondante du premier composant semi-conducteur (10), et une première borne de grille (16) ou une borne de base est reliée par une couche de mise en contact (7) à une électrode de grille ou à une électrode de base correspondante du premier composant semi-conducteur (10).

8. Module à semi-conducteur (1) selon l'une quelconque des revendications 4 à 7, **caractérisé en ce qu'**à l'intérieur du boîtier (3), une deuxième borne de drain (22A) ou une borne de collecteur est reliée par une couche de mise en contact (7) à une électrode de drain ou à une électrode de collecteur correspondante du deuxième composant semi-conducteur (20), et une deuxième borne de source (24A) ou une borne d'émetteur est reliée par une couche de mise en contact (7) à une première électrode de source ou à une électrode d'émetteur correspondante du deuxième composant semi-conducteur (20), et une deuxième borne de grille (26) ou une borne de base est reliée par une couche de mise en contact (7) à une électrode de grille ou à une électrode de base du deuxième composant semi-conducteur (20) .

9. Module à semi-conducteur (1) selon la revendication 7 ou 8, **caractérisé en ce que** seules les bornes de grille (16, 26) ou les bornes de base des deux composants semi-conducteurs (10, 20) sont mises en contact électrique avec une carte de circuits imprimés.

10. Module à semi-conducteur (1) selon l'une quelconque des revendications 1 à 9, **caractérisé en ce qu'**une partie d'extrémité (9.1) d'un fil de courant de phase (9) d'une machine électrique est l'élément de contact (5).

11. Module à semi-conducteur (1) selon l'une quelconque des revendications 1 à 10, **caractérisé en ce que** le boîtier (3) est réalisé sous forme de boîtier moulé.

12. Module à semi-conducteur (1) selon l'une quelconque des revendications 1 à 11, **caractérisé en ce que** des surfaces exposées, tournées vers l'extérieur, des deux premiers éléments conducteurs électriques (12, 22) terminent respectivement en affleurement avec une face inférieure (3.2) du boîtier (3).

13. Module à semi-conducteur (1) selon l'une quelconque des revendications 1 à 12, **caractérisé en ce que** des surfaces exposées, tournées vers l'extérieur, des deux deuxièmes éléments conducteurs électriques (14, 24) terminent respectivement en affleurement avec une face supérieure (3.2) du boîtier (3).

14. Module à semi-conducteur (1) selon la revendication 12 ou 13, **caractérisé en ce que** le boîtier (3) est posé par sa face inférieure (3.2) sur une carte de circuits imprimés ou un puits thermique.

15. Module à semi-conducteur (1) selon l'une quelconque des revendications 12 à 14, **caractérisé en ce que** le boîtier (3) est posé par sa face supérieure (3.1) sur la carte de circuits imprimés ou le puits thermique.
